# EUROPEAN PATENT APPLICATION

(11) **EP 4 550 670 A1**
(43) Date of publication of application: **07.05.2025**
(21) Application number: 24210623.5
(22) Date of filing: 04.11.2024
(51) Int. Cl.: H03M 9/00

(54) **TWO-STAGE DATA SERIALIZATION**

(30) Priority: 02.11.2023 US 202363547017 P
(71) Applicant: Marvell Asia Pte Ltd, Singapore 369522 (SG)
(72) Inventor: Shukla, Umesh Kumar, 560066 Bangalore (IN); Ramakrishna, Purushotham Brahmavar, 560026 Bangalore (IN); Guo, Zhendong, San Jose, CA, 95129 (US); Liu, Peng, Fremont, CA, 94539 (US); Li, Yihui, San Jose, CA, 95136 (US); Ma, Xin, San Jose, CA, 95130 (US)
(74) Representative: Grünecker Patent- und Rechtsanwälte PartG mbB

(57) **Abstract**

A transmission driver for serial communication includes first multiplexing circuitry configured to partially serialize a data group into data subgroups based on an in-phase clock, and to delay a quadrature clock corresponding to the in-phase clock. The delay is based on latency of the partial serialization. The transmission driver also includes second multiplexing circuitry having a source-series terminated (SST) driver configured to serialize the data subgroups into a serial data stream based on the delayed quadrature clock. The first multiplexing circuitry may be configured to partially serialize the data group into the data subgroups by arranging a four-bit data group into a pair of two-bit data groups, and the second multiplexing circuitry may be configured to serialize the data subgroups into the serial data stream by arranging the pair of two-bit data groups into the serial data stream.

## Description

### Cross Reference to Related Application

This disclosure claims the benefit of copending, commonly-assigned United States Provisional Patent Application No. 63/547,017, filed November 2, 2023, which is hereby incorporated by reference herein in its entirety.

### Field of Use

This disclosure relates to system-on-chip (SOC) devices including multiple chiplets. More particularly, this disclosure relates to two-stage data serialization (e.g., 4:1 serialization), as may be used when driving a serial communication link between two chiplets.

### Background

The background description provided herein is for the purpose of generally presenting the context of the disclosure. Work of the inventors hereof, to the extent the work is described in this background section, as well as aspects of the description that may not otherwise qualify as prior art at the time of filing, are neither expressly nor impliedly admitted to be prior art against the subject matter of the present disclosure.

As noted above, SOC devices may include multiple chiplets, as well as one or more "main die" chips. The chiplets may be coupled to the one or more main die chips and/or to each other. SOC devices may transmit serialized data between the "main die" and one or more chiplets, or between chiplets, using transmission driver circuitry. Illustrative transmission driver topologies (e.g., for use over short-reach links, including extra-short-reach or ultrashort-reach links) include current mode logic (CML) and voltage mode source-series terminated (SST) circuitry. In some implementations, the CML topology is used for high-speed applications. In other implementations, the SST topology is used for low-power applications.

### Summary

In accordance with implementations of the subject matter of this disclosure, a transmission driver for serial communication includes first multiplexing circuitry configured to partially serialize a data group into data subgroups based on an in-phase clock, and to delay a quadrature clock corresponding to the in-phase clock, where the delay is based on a latency of the partial serialization. The transmission driver also includes second multiplexing circuitry having a source-series terminated (SST) driver configured to serialize the data subgroups into a serial data stream based on the delayed quadrature clock.

In a first implementation of such a transmission driver, the first multiplexing circuitry may be configured to partially serialize the data group into the data subgroups by arranging a four-bit data group into a pair of two-bit data groups, and the second multiplexing circuitry may be configured to serialize the data subgroups into the serial data stream by arranging the pair of two-bit data groups into the serial data stream.

In a second implementation of such a transmission driver, the first multiplexing circuitry may further include a unit interval shifter.

According to a first aspect of that second implementation, the unit interval shifter may be configured to delay a time when bits of the data group are partially serialized.

In a third implementation of such a transmission driver, the SST driver may include a first transistor and a second transistor to serialize the data subgroups into the serial data stream based on the delayed quadrature clock.

According to a first aspect of that third implementation, the transmission driver may further include a first logic gate and a second logic gate configured to respectively control the first transistor and the second transistor, where the first logic gate and the second logic gate are coupled between the first multiplexing circuitry and the second multiplexing circuitry, a gate of the first transistor is coupled to an output of the first logic gate, and a gate of the second transistor is coupled to an output of the second logic gate.

In a first instance of that first aspect, the first logic gate may be a NAND gate and the second logic gate may be a NOR gate.

In a second instance of that first aspect, the SST driver may further include a third transistor and a fourth transistor to serialize the data subgroups into the serial data stream based on the delayed quadrature clock, where the third transistor has the same source and drain connections as the first transistor, and the fourth transistor has the same source and drain connections as the second transistor, and the transmission driver may further include a third logic gate and a fourth logic gate configured to respectively control the third transistor and the fourth transistor.

In a third instance of that first aspect, a shared pair of inputs may be provided to the first logic gate and the second logic gate.

In a first alternative of that third instance, the shared pair of inputs may include a bit from one of the data subgroups, and the delayed quadrature clock.

In a fourth implementation of such a transmission driver, the SST driver may further include at least one impedance-tuning transistor configured to control an impedance associated with transmitting the serial communication.

In accordance with implementations of this disclosure, a method of operating a transmission driver for serial communication includes partially serializing, at first multiplexing circuitry, a data group into data subgroups based on an in-phase clock, delaying, at the first multiplexing circuitry, a quadrature clock corresponding to the in-phase clock, where the delay is based on a latency of the partial serializing, and serializing, at a source-series terminated (SST) driver of second multiplexing circuitry and based on the delayed quadrature clock, the data subgroups into a serial data stream.

In a first implementation of such a method, the partially serializing may include arranging a four-bit data group into a pair of two-bit data groups, and the serializing may include arranging the pair of two-bit data groups into the serial data stream.

A second implementation of such a method may further include delaying, at a unit interval shifter of the first multiplexing circuitry, a time when bits of the data group are partially serialized.

In a third implementation of such a method, the serializing, at the SST driver and based on the delayed quadrature clock, may include serializing using a first transistor and a second transistor.

A first aspect of that third implementation may further include respectively controlling the first transistor and the second transistor using a first logic gate and a second logic gate, where the first logic gate and the second logic gate are coupled between the first multiplexing stage and the second multiplexing stage, a gate of the first transistor is coupled to the first logic gate, and a gate of the second transistor is coupled to the second logic gate.

In a first instance of that first aspect, controlling the first transistor using the first logic gate may include using a NAND gate, and controlling the second transistor using the second logic gate comprises using a NOR gate.

In a second instance of that first aspect, the serializing, at the SST driver and based on the delayed quadrature clock, may further include serializing using a third transistor and a fourth transistor, and the method further comprises respectively controlling the third transistor and the fourth transistor using a third logic gate and a fourth logic gate.

A third instance of that first aspect may further include providing, from the first multiplexing circuitry, a shared pair of inputs to the first logic gate and the second logic gate.

In a first alternative of that third instance, providing the shared pair of inputs comprises providing a bit from one of the data subgroups, and the delayed quadrature clock.

A fourth implementation of such a method may further include controlling an output impedance associated with transmitting the serial communication using an impedance-tuning transistor of the second multiplexing stage.

In accordance with implementations of this disclosure, source-series terminated (SST) driver circuitry configured to provide a serial data stream based at least in part on a delayed quadrature clock includes a first transistor coupled to a first logic gate, where the first logic gate is configured to provide control signals for the first transistor based on first and second bits of a two-bit group and the delayed quadrature clock, and a second transistor coupled to a second logic gate, where the second logic gate is configured to provide control signals for the second transistor based on the first and second bits of the two-bit group and the delayed quadrature clock, where the first transistor and the second transistor are configured to serialize, based on the respective control signals, the two-bit group into the serial data stream.

### Brief Description of the Drawings

Further features of the disclosure, its nature and various advantages, will be apparent upon consideration of the following detailed description, taken in conjunction with the accompanying drawings, in which like reference characters refer to like parts throughout, and in which:
FIG. 1 is a block diagram of a system-on-chip (SOC) integrated circuit device including a transmission driver, in accordance with implementations of the subject matter of this disclosure;
FIG. 2 is a block diagram of a transmission driver, in accordance with implementations of the subject matter of this disclosure;
FIG. 3 is a circuit diagram of a transmission driver, in accordance with implementations of the subject matter of this disclosure;
FIG. 4 is a timing diagram associated with data serialization, in accordance with implementations of the subject matter of this disclosure; and
FIG. 5 is a flow diagram illustrating a method for two-stage data serialization, in accordance with implementations of the subject matter of this disclosure.

### Detailed Description

SOC devices may include multiple chiplets, and may transmit serialized data between respective chiplets using transmission driver circuitry. Voltage mode source-series terminated (SST) circuitry is a type of transmission driver circuitry that may be used for low-power applications (e.g., while providing a target amount of voltage swing as part of the transmission process).

Transmission driver serialization circuitry may require high-speed clocks, which can be implemented using half-rate or quarter-rate clocks. Compared to the half-rate clock, the quarter-rate clock has better power efficiency because it requires less clock power. In some implementations, a quarter-rate clock is used with a 4:1 mux to achieve a final data serialization that may occur at, or upstream of, the transmission driver circuitry.

There are tradeoffs associated with implementing a 4:1 mux (or any other mux) at, or upstream of, the transmission driver circuitry. When implemented upstream of the transmission driver (e.g., at pre-driver circuitry), a single unit interval (UI) pulse may need to be generated for each tick of the quarter-rate clock, which increases power consumption and forces the transmission driver to be a fullrate driver. Moreover, in an upstream implementation, there is a risk of duty-cycle distortion at the transmission driver resulting from calibrating the quarter-rate clock upstream of the transmission driver circuitry or the pre-driver circuitry.

However, if a 4:1 mux is implemented at the transmission driver circuitry, there are other risks -- viz., increased serialization noise and bandwidth degradation (e.g., because of self-loading at the circuitry). Compensating for that increased serialization noise and bandwidth degradation may require increasing the size of devices within the driver and pre-driver circuits, thereby increasing the size of the applicable chiplet and also the power consumption of the corresponding data serialization and transmission driver circuitry.

In accordance with implementations of the subject matter of this disclosure, circuitry for performing two-stage data serialization is provided. For example, the two stages may be two cascaded 2:1 stages (e.g., with one operation performed at each stage), including a first stage of serializing data (e.g., at pre-driver circuitry) from 4:2, and a second stage of serializing data (e.g., at driver circuitry) from 2:1. The resulting transmission driver obviates the need to generate a power-intensive UI pulse, and therefore provides low-power data serialization and transmission. Such a transmission driver may also provide a reduced load (compared to the aforementioned topologies) to support higher-bandwidth data transmissions.

The transmission driver circuitry for performing the two-stage data serialization includes an input stage for receiving four-bit groups of data to be serialized. For example, the input circuitry may be coupled to any suitable chiplet (e.g., a chiplet that processes data and is configured to provide the processed data to another chiplet of an SOC).

The transmission driver circuitry also includes first multiplexing circuitry that performs the 4:2 data serialization and conditions the 2-bit groups of data to be further serialized in a 2:1 data serialization. The conditioning may include delaying a clock (e.g., a quadrature clock corresponding to an in-phase clock used in connection with the 4:2 data serialization) based on a latency associated with the first stage of (e.g., 4:2) data serialization, and optionally includes shifting some bits of the initial four-bit group by two UIs.

The transmission driver circuitry also includes a second multiplexing stage that performs the second stage of (e.g., 2:1) data serialization based on the delayed clock. In some implementations, the second multiplexing stage is also configured to provide the serial data stream over a serial communication link.

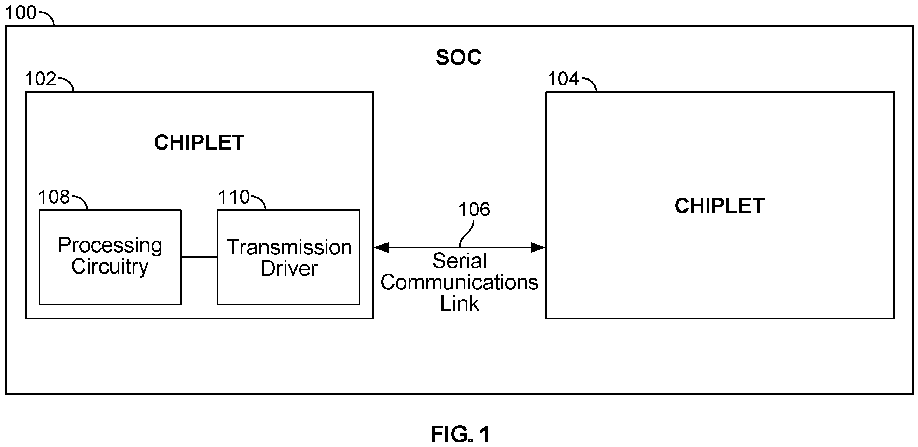

The subject matter of this disclosure may be better understood by reference to FIGS. 1-5.

FIG. 1 is a high-level block diagram of a portion of a system-on-chip (SOC) integrated circuit device 100. As shown, SOC 100 includes chiplet 102 and chiplet 104, which are connected by serial communications link 106 (e.g., a short-reach link). While serial communications link 106 is typically unidirectional, as shown in FIG. 1 it can also be bidirectional. In a unidirectional implementation, the communication link may be structured such that there are a pair of unidirectional connections, each connection enabling data flow in opposite directions. The subject matter of this disclosure may be implemented for any transmission driver (e.g., transmission driver 110) that serializes and communicates data (e.g., to chiplet 102 or 104, or to any other suitable device) using a serial communications link 106. While two chiplets are shown in FIG. 1, this is merely illustrative; SOC 100 may include any suitable number of chips and chiplets.

Chiplet 102 includes processing circuitry 108 and transmission driver 110 for providing data to serial communications link 106. As shown and described in connection with at least FIGS. 1-3, transmission driver 110 includes pre-driver circuitry (e.g., the aforementioned input circuitry and the aforementioned first multiplexing circuitry) and driver circuitry (e.g., the aforementioned second multiplexing circuitry). Processing circuitry 108 may perform any suitable tasks, and generally provides a data stream that is to be serialized at transmission driver 110 and communicated to chiplet 104 over serial communications link 106.

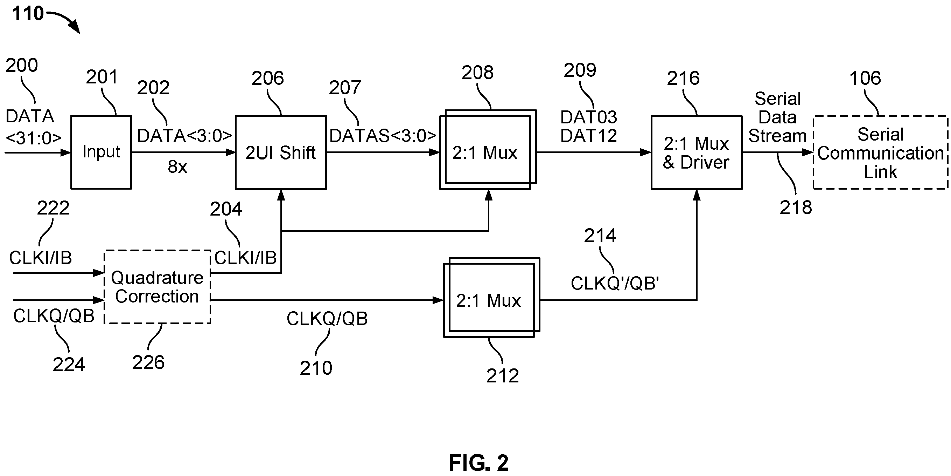

FIG. 2 is a block diagram of transmission driver 110 (e.g., for a short-reach link), in accordance with implementations of the subject matter of this disclosure. Transmission driver 110 includes first multiplexing circuitry (e.g., including at least the pair of 2:1 muxes 208), which may be referred to as pre-driver circuitry, and second multiplexing circuitry (e.g., including at least 2:1 mux and driver 216), which may be referred to as driver circuitry. The aforementioned first and second multiplexing circuitry may respectively perform the first and second stages of the two-stage data serialization of the subject matter of this disclosure.

Data flow through the block diagram (e.g., from left to right, in the orientation of the drawing) of transmission driver 110 may be described as follows. Data, is received at input circuitry 201 and provided as a four-bit group of data, i.e., DATA<3:0> 202, to 2UI shifter 206. In some implementations, as shown in FIG. 2, the data received at input circuitry 201 is a 32-bit group of data (i.e., DATA<31:0> 200). This 32-bit group of data may be divided into eight 4-bit groups of data (e.g., at input circuitry 201). These eight 4-bit groups of data may be provided sequentially to UI shifter 206 or may be provided in parallel to eight instances of UI shifter 206.

The 2UI shifter 206 conditions the data 202 for 4:2 multiplexing by delaying, by two UIs, propagation of two bits of the four-bit group. For example, the four-bit group of data 202 may include first and second (with respect to when the data is multiplexed) pairs of data, and 2UI shifter 206 may shift, by two UIs, a bit (e.g., the third bit of the four-bit group) of the first pair and a bit (e.g., the fourth bit of the four-bit group) of the second pair, so that respective bits of each pair can then be multiplexed at the 2:1 muxes 208 with a proper timing sequence (e.g., where a first 2:1 mux operation may occur on data with no propagation delay, and a second 2:1 mux operation may occur on data with a propagation that was delayed by two UIs). The 2UI shifter 206 applies the two-UI delay based on a timing from clock 204. As shown, clock 204 includes an in-phase clock (i.e., "I") as well as inverted in-phase clock "IB", which is the opposite of the in-phase clock.

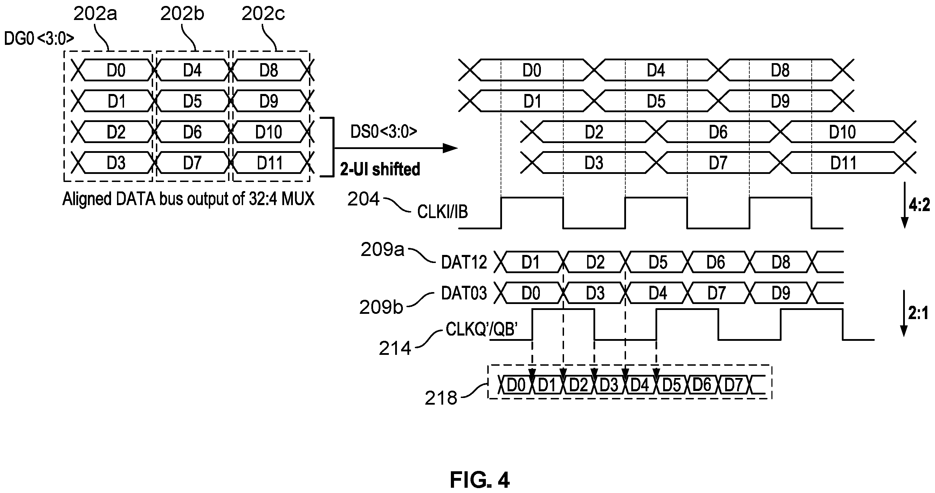

The partially-shifted data 207 (i.e., DATAS<3:0>, which is annotated with an "S" to denote the shifting of two of the four bits). For example, as further shown in FIG. 4, DATAS<3:0> may include four bits (i.e., D0, D1, D2, and D3), of which the propagations of D2 and D3 have been delayed by two UIs. Because DATAS<3:0> exits 2UI shifter 206 with as partially shifted data 207, this data can be provided to the pair of 2:1 muxes 208 with a timing that permits 4:2 multiplexing of a four-bit group into a pair of two-bit groups, each including an unshifted bit and a shifted bit. For example, as further shown in FIG. 4, DATAS<3:0> may be arranged into the pair of groups DAT03 (i.e., a two-bit group including D0 and D3) and DAT12 (i.e., a two-bit group including D1 and D2).

The pair of 2:1 muxes 208 relies on clock 204 to serialize the partially-shifted four-bit group of data into two two-bit groups of data. As shown in FIG. 2, the first (i.e., "D0") and fourth (i.e., "D3") bits of the four-bit group are provided as the first two-bit pair, DAT03, of data 209, and the second (i.e., "D1") and third (i.e., "D2") bits of the four-bit group are provided as the second two-bit pair, DAT12, of data 209. In this illustrative data flow, the third and fourth bits were shifted at 2UI shifter 206 (e.g., as shown in FIG. 4), although any two bits may be shifted.

In parallel with 2:1 muxes 208 are a pair of 2:1 muxes 212, which may be provided as a replica circuit of 2:1 muxes 208. That is, 2:1 muxes 212 are configured to delay, based on a latency associated with the serializing at 2:1 muxes 208, clock 210. As shown, clock 210 includes a quadrature clock (i.e., "Q") corresponding to the quadrature component of clock 204, as well as inverted quadrature clock "QB", which is the inverse of the quadrature clock).

In some implementations, transmission driver 110 includes quadrature corrector 226. Quadrature corrector 226 is configured to provide the in-phase component of clock 204 and the quadrature component of clock 210 with an offsetcorrected in-phase/quadrature relationship (e.g., compared to the incoming in-phase component of clock 222 and the incoming quadrature component of clock 224). Quadrature correction 226 thus improves an alignment between the first multiplexing stage and the second multiplexing stage.

The pair of two-bit groups (or two-bit pairs) of data 209 are serialized, into serial data stream 218, at 2:1 mux and driver 216. The serialization at 2:1 mux and driver 216 is performed based on clock 214 (e.g., based on the delayed quadrature clock). The 2:1 mux and driver 216 may additionally include SST driver circuitry for driving the transmission of serial data stream 218 over serial communication link 106 (which, as depicted with dashed lines, is coupled to, but not a part of, transmission driver 110).

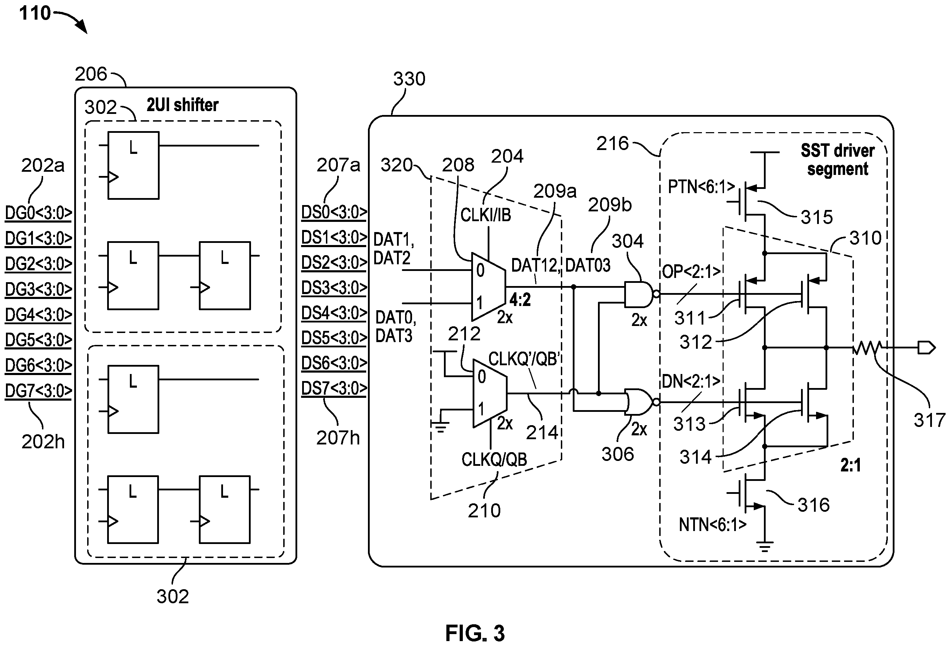

FIG. 3 is a circuit diagram of transmission driver 110, in accordance with implementations of the subject matter of this disclosure. The circuit diagram shows illustrative implementations of 2UI shifter 206, 2:1 mux 208, 2:1 mux 212, and 2:1 mux and driver 216, as annotated. For illustrative purposes, a 32-bit group of data is shown as being divided (e.g., at input circuitry 201) into eight respective groups of four-bit data (including DG0<3:0> through DG7<3:0>, which are labeled 202a through 202h due to corresponding to four-bit group of data 202). Each data group ("DG") may be processed through transmission driver 110, as described in connection with FIG. 2 and in connection with implementations of this disclosure.

2UI shifter 206 includes two arrangements of latches 302 to partially shift a 4-bit group of data. In some implementations, there may be eight instances of 2UI shifter 206 to process eight 4-bit groups of data in parallel. Each arrangement of latches 302 is configured to receive two bits, with a first of the two bits passing through (e.g., without delay) the latch of the top signal path of the arrangement 302, and the second of the two bits passing through (e.g., with a 2UI delay, based on the second latch) the two latches of the bottom signal path of the arrangement 302. Each data group 202a through 202h leaves 2UI shifter 206 as a corresponding shifted data group 207a through 207h (which are labeled as such due to corresponding to shifted four-bit group of data 207).

The shifted four-bit data groups 207a through 207h are processed at a pair (as denoted by "2x" in FIG. 3, next to the mux block 208) of 2:1 muxes 208. Because these 2:1 muxes 208 process four-bits of data, they effectively perform a 4:2 multiplexing operation and are annotated accordingly. The two discrete 2:1 muxes 208 are used to process the four bits of data (e.g., D0, D1, D2, and D3, as further shown in FIG. 4) into a pair of two-bit data groups (e.g., DAT12 and DAT03). During this processing, D0 and D1 may be arranged into first and second two-bit groups; then, based on the 2UI shift, DAT2 and DAT3 may be arranged to complete each of the respective two-bit groups. As shown, this 4:2 multiplexing is performed based on a timing from clock 204. The pair of two-bit data groups 209a and 209b are provided to logic gates 304 and 306 for 2:1 multiplexing and serialization.

In parallel with the two 2:1 muxes 208 are the two 2:1 muxes 212. As mentioned, these 2:1 muxes 212 are designed to generate a delay, in clock 210, that corresponds to the latency associated with (i.e., the time required for) multiplexing the data at 2:1 muxes 208. Accordingly, the multiplexing at the two (as denoted by "2x" in the figure next to the mux block 212) 2:1 muxes 212 is performed based on a timing from clock 210 to provide the delayed clock 214 (e.g., a delayed quadrature clock).

With respect to the multiple stages of transmission driver, the first multiplexing stage occurs at the four muxes of block 320, based in part on the partially-delated data propagation provided by 2UI shifter 206. The second multiplexing stage occurs at the 2:1 mux and driver 216, which may otherwise be referred to as the SST driver segment. In between circuitry of the first multiplexing stage and circuitry of the second multiplexing stage is a first pair of logic gates (e.g., NAND gates 304) and a second pair of logic gates (e.g., NOR gates 306). These logic gates take, as a shared pair of inputs, (i) a bit from the two-bit data group (e.g., one of data groups 209a or 209b), and (ii) the delayed clock 214. Based on these inputs, NAND gates 304 and NOR gates 306 control how SST driver segment 216 performs the final 2:1 multiplexing operation and drives a serial data transmission based on this final multiplexing operation. In some implementations, the first logic gate and the second logic gate may be considered part of the SST driver segment 216.

SST driver segment 216 includes a 2:1 mux 310, which includes transistors 311, 312, 313, and 314. SST driver segment 216 also includes impedance-tuning transistors 315 and 316, which can be configured to control an impedance associated with transmitting the serialized data through resistor 317 and onto serial communications link 106. As shown, those impedance-tuning transistors 315 and 316 are coupled in series with the first transistor 311 and the second transistor 313; they are also coupled in series with the third transistor 312 and the fourth transistor 314. Moreover, the first transistor 311 and the third transistor 312 are coupled in parallel, as are the second transistor 313 and the fourth transistor 314.

To perform the 2:1 multiplexing operation, 2:1 mux 310 relies on timing signals from two NAND gates 304 (which respectively control transistors 311 and 312, which may be referred to as a first transistor and a third transistor of the SST driver segment 216) and two NOR gates 306 (which respectively control transistors 313 and 314, either of which may be referred to as a second transistor and a fourth transistor of the SST driver segment 216) to select and serialize the bits of each two-bit data groups 209a and 209b.

The NAND gates 304 (e.g., each of which may be coupled to exactly one of transistor 311 or transistor 312) and the NOR gates 306 (e.g., each of which may be coupled to exactly one of transistor 313 or transistor 314) may control the transistors of SST driver segment 216 as follows. Initially, a first bit of a two-bit data group (e.g., either of data groups 209a or 209b) may be provided, along with the delayed clock 214, as inputs to those logic gates. The logic gates will generate respective '1' or '0' outputs based on the value of the first bit and the value of the clock, which will drive first transistor 311 and second transistor 313 (and, in some implementations, third transistor 312 and fourth transistor 314) to push the value of the first bit across resistor 317. Then, the second bit of the two-bit data group will be pushed across resistor 317 using the same approach.

With respect to an illustrative 32-bit input (e.g., as is distributed across eight four-bit data groups 202a through 202h), transmission driver 110 may include eight instances of 2UI shifter 206 and of circuitry 330. These eight respective instances may process the eight four-bit group in parallel and provide eight bits (e.g., including one bit from each four-bit group) to an 8-bit digital to analog converter (DAC) (not shown). This 8-bit DAC may convert the aforementioned eight bits into a corresponding analog voltage that can be provided to serial communications link 106. In other implementations, there may be a 64-bit input 16 instances of 2UI shifter 206, and a 16-bit DAC.

FIG. 4 is a timing diagram depicting how respective four-bit groups of data are serialized, in accordance with implementations of the subject matter of this disclosure. In some implementations, the timing diagram of FIG. 4 corresponds to how transmission driver 110 implements a 2UI shift, a first 4:2 multiplexing stage, and a second 2:1 multiplexing stage to serialize and transmit data.

Initially, respective four-bit groups of data (e.g., data group 202a through 202c) are provided as aligned groups of data (e.g., at the bus output of a 32:4 multiplexer). As shown, two of the four bits of data (e.g., the bottom two bits, as shown, or any other two bits) get shifted by two unit intervals (e.g., at 2UI shifter 206). Thus, a shifted four-bit group of data (e.g., DS0<3:0>, or data groups 207a through 207c) is provided to a 4:2 multiplexer (e.g., 2:1 mux 208). According to clock 204, including an in-phase clock and an inverted in-phase clock, the shifted four-bit groups of data are multiplexed by a 4:2 process into pairs of two-bit groups of data (e.g., data groups 209a through 209b). According to clock 214, including a shifted quadrature clock and a shifted inverted quadrature clock (where the quadrature component corresponds to the in-phase component of clock 204, and the shift corresponds to the latency of the 4:2 multiplexing operation), the pairs of two-bit groups of data are multiplexed by a 2:1 process into serial data stream 216. In some implementations, serial data stream 216 is provided from a first chiplet to a second chiplet over a serial communications link (e.g., a short-reach link).

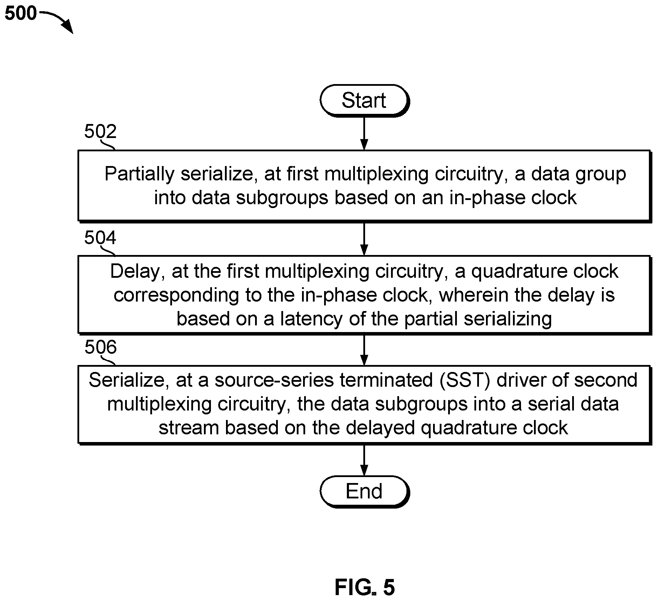

FIG. 5 is a flow diagram of a method 500 for two-stage data serialization, in accordance with implementations of the subject matter of this disclosure. In some implementations, method 500 is executed by transmission driver 110.

At 502, method 500 includes partially serializing, at first multiplexing circuitry (e.g., including 2:1 muxes 208) a data group (e.g., data group 202) into data subgroups (e.g., data groups 209a and 209b) based on an in-phase clock (e.g., clock 204, including an in-phase component and a component that is an inverse of the in-phase component). In some implementations, method 500 also includes, at or before 502, receiving, at input circuitry (e.g., input circuitry 201), data to be serialized (e.g., data group 200), the data to be serialized including one or more four-bit groups. For example, the data to be serialized may be a 32-bit or 64-bit group of data that comprises and can be processed into respective four-bit groups of data. In some implementations, the data to be serialized is provided by processing circuitry (e.g., processing circuitry 108) of a first chiplet (e.g., chiplet 102) of an SOC device (e.g., SOC 100).

In some implementations, method 500 also includes, at 504, delaying (e.g., by two UIs, using 2UI shifter 206) a time when bits of the second pair of the pair of two-bit groups are serialized. That is, method 500 may include delaying a propagation of some (e.g., at least half) of the bits of the data group. For example, that delaying may transform a four-bit data group 202 into a partially-shifted four-bit data group 207, in which two of the four bits have been shifted to propagate with delays.

At 504, method 500 includes delaying, at the first multiplexing circuitry (e.g., at 2:1 muxes 212), a quadrature clock (e.g., clock 210) corresponding to the in-phase clock, wherein the delay is based on a latency of the partial serializing at 502. For example, 2:1 muxes 212 may be matched to 2:1 muxes 208, so that the delay at 504 is matched to the time associated with the first-stage or 4:2 multiplexing performed at 502.

At 506, method 500 includes serializing, at a source-series terminated (SST) driver (e.g., SST driver segment 216) of second multiplexing circuitry, the data subgroups (e.g., data groups 209a and 209b) into a serial data stream (e.g., serial data stream 218) based on the delayed quadrature clock generated at 506.

In some implementations, method 500 also includes providing the serialized data onto a serial communications link (e.g., to serial communications link 106, based at least in part on configuring one or more impedance-tuning transistors, including transistor 315 and/or transistor 316). In some implementations, the data to be serialized is generated at a first chiplet (e.g., chiplet 102), processed (e.g., at least by transmission driver 110), and provided as a serial data stream to a second chiplet (e.g., chiplet 104), where both the first and second chiplet are on a SOC device (e.g., SOC 100) .

As described in connection with method 500, the first multiplexing stage may include the operations at 502 and may make use of 2:1 muxes 208 and 2:1 muxes 212; it may optionally also make use of 2UI shifter 206. The second multiplexing stage may include the operations at 506 and may make use of 2:1 mux and driver 216, which is also referred to as SST driver segment 216. That first multiplexing circuitry may perform the first operation (e.g., a 4:2 multiplexing operation) of the two-stage data serialization, and that second multiplexing stage may perform the second operation (e.g., a 2:1 multiplexing operation) of the two-stage data serialization.

While implementations of this disclosure are provided in the context of 4:1 data serialization, this scope of serialization is merely illustrative. Indeed, implementations of this disclosure may be similarly applied to any two-stage data serialization (e.g., 8:1, 16:1, 32:1, or 64:1), in which a first data group is partially serialized into subgroups and the subgroups are serialized based at least in part on a delayed clock, where the delay of the clock corresponds to a latency of the partial serialization.

Thus it is seen that two-stage data serialization circuitry, and a method for operating the two-stage data serialization circuitry, have been provided.

As used herein and in the claims which follow, the construction "one of A and B" shall mean "A or B."

It is noted that the foregoing is only illustrative of the principles of the invention, and that the invention can be practiced by other than the described implementations, which are presented for purposes of illustration and not of limitation, and the present invention is limited only by the claims which follow.

**The following is a list of further preferred embodiments of the invention:**
Embodiment 1. A transmission driver for serial communication, the transmission driver comprising:
   first multiplexing circuitry configured to:
   partially serialize a data group into data subgroups based on an in-phase clock, and
   delay a quadrature clock corresponding to the in-phase clock, wherein the delay is based on a latency of the partial serialization; and
   second multiplexing circuitry comprising a source-series terminated (SST) driver configured to serialize the data subgroups into a serial data stream based on the delayed quadrature clock.
Embodiment 2. The transmission driver of embodiment 1, wherein:
   the first multiplexing circuitry is configured to partially serialize the data group into the data subgroups by arranging a four-bit data group into a pair of two-bit data groups; and
   the second multiplexing circuitry is configured to serialize the data subgroups into the serial data stream by arranging the pair of two-bit data groups into the serial data stream.
Embodiment 3. The transmission driver of embodiment 1, wherein the first multiplexing circuitry further comprises a unit interval shifter.
Embodiment 4. The transmission driver of embodiment 3, wherein the unit interval shifter is configured to delay a time when bits of the data group are partially serialized.
Embodiment 5. The transmission driver of embodiment 1, wherein the SST driver comprises a first transistor and a second transistor to serialize the data subgroups into the serial data stream based on the delayed quadrature clock.
Embodiment 6. The transmission driver of embodiment 5, further comprising a first logic gate and a second logic gate configured to respectively control the first transistor and the second transistor, wherein:
   the first logic gate and the second logic gate are coupled between the first multiplexing circuitry and the second multiplexing circuitry;
   a gate of the first transistor is coupled to an output of the first logic gate; and
   a gate of the second transistor is coupled to an output of the second logic gate.
Embodiment 7. The transmission driver of embodiment 6, wherein the first logic gate is a NAND gate and the second logic gate is a NOR gate.
Embodiment 8. The transmission driver of embodiment 6, wherein:
   the SST driver further comprises a third transistor and a fourth transistor to serialize the data subgroups into the serial data stream based on the delayed quadrature clock, wherein:
   the third transistor has the same source and drain connections as the first transistor, and
   the fourth transistor has the same source and drain connections as the second transistor; and
   the transmission driver further comprises a third logic gate and a fourth logic gate configured to respectively control the third transistor and the fourth transistor.
Embodiment 9. The transmission driver of embodiment 6, wherein a shared pair of inputs is provided to the first logic gate and the second logic gate.
Embodiment 10. The transmission driver of embodiment 9, wherein the shared pair of inputs comprises:
   a bit from one of the data subgroups; and
   the delayed quadrature clock.
Embodiment 11. The transmission driver of embodiment 1, wherein the SST driver further comprises at least one impedance-tuning transistor configured to control an impedance associated with transmitting the serial communication.
Embodiment 12. A method of operating a transmission driver for serial communication, the method comprising:
   partially serializing, at first multiplexing circuitry, a data group into data subgroups based on an in-phase clock;
   delaying, at the first multiplexing circuitry, a quadrature clock corresponding to the in-phase clock, wherein the delay is based on a latency of the partial serializing; and
   serializing, at a source-series terminated (SST) driver of second multiplexing circuitry and based on the delayed quadrature clock, the data subgroups into a serial data stream based on the delayed quadrature clock.
Embodiment 13. The method of embodiment 12, wherein:
   the partially serializing comprises arranging a four-bit data group into a pair of two-bit data groups; and
   the serializing comprises arranging the pair of two-bit data groups into the serial data stream.
Embodiment 14. The method of embodiment 12, further comprising delaying, at a unit interval shifter of the first multiplexing circuitry, a time when bits of the data group are partially serialized.
Embodiment 15. The method of embodiment 12, wherein the serializing, at the SST driver and based on the delayed quadrature clock, comprises serializing using a first transistor and a second transistor.
Embodiment 16. The method of embodiment 15, further comprising respectively controlling the first transistor and the second transistor using a first logic gate and a second logic gate, wherein:
   the first logic gate and the second logic gate are coupled between the first multiplexing stage and
   the second multiplexing stage;
   a gate of the first transistor is coupled to the first logic gate; and
   a gate of the second transistor is coupled to the second logic gate.
Embodiment 17. The method of embodiment 16, wherein:
   controlling the first transistor using the first logic gate comprises using a NAND gate; and
   controlling the second transistor using the second logic gate comprises using a NOR gate.
Embodiment 18. The method of embodiment 16, wherein the serializing, at the SST driver and based on the delayed quadrature clock, further comprises serializing using a third transistor and a fourth transistor, and the method further comprises respectively controlling the third transistor and the fourth transistor using a third logic gate and a fourth logic gate.
Embodiment 19. The method of embodiment 16, further comprising providing, from the first multiplexing circuitry, a shared pair of inputs to the first logic gate and the second logic gate.
Embodiment 20. The method of embodiment 17, wherein providing the shared pair of inputs comprises providing:
   a bit from one of the data subgroups; and
   the delayed quadrature clock.
Embodiment 21. The method driver of embodiment 12, further comprising controlling an output impedance associated with transmitting the serial communication using an impedance-tuning transistor of the second multiplexing stage.
Embodiment 22. Source-series terminated (SST) driver circuitry configured to provide a serial data stream based at least in part on a delayed quadrature clock, the SST driver circuitry comprising:
   a first transistor coupled to a first logic gate, wherein the first logic gate is configured to provide control signals for the first transistor based on first and second bits of a two-bit group and the delayed quadrature clock; and
   a second transistor coupled to a second logic gate, wherein the second logic gate is configured to provide control signals for the second transistor based on the first and second bits of the two-bit group and the delayed quadrature clock; wherein:
      the first transistor and the second transistor are configured to serialize, based on the respective control signals, the two-bit group into the serial data stream.

## Claims

1. A transmission driver for serial communication, the transmission driver comprising:
first multiplexing circuitry configured to:
partially serialize a data group into data subgroups based on an in-phase clock, and
delay a quadrature clock corresponding to the in-phase clock, wherein the delay is based on a latency of the partial serialization; and
second multiplexing circuitry comprising a source-series terminated (SST) driver configured to serialize the data subgroups into a serial data stream based on the delayed quadrature clock.

2. The transmission driver of claim 1, wherein:
the first multiplexing circuitry is configured to partially serialize the data group into the data subgroups by arranging a four-bit data group into a pair of two-bit data groups; and
the second multiplexing circuitry is configured to serialize the data subgroups into the serial data stream by arranging the pair of two-bit data groups into the serial data stream.

3. The transmission driver of one of claims 1 or 2, wherein the first multiplexing circuitry further comprises a unit interval shifter.

4. The transmission driver of claim 3, wherein the unit interval shifter is configured to delay a time when bits of the data group are partially serialized.

5. The transmission driver of one of claims 1 to 3, wherein the SST driver comprises a first transistor and a second transistor to serialize the data subgroups into the serial data stream based on the delayed quadrature clock, and/or
further comprising a first logic gate and a second logic gate configured to respectively control the first transistor and the second transistor, wherein:
the first logic gate and the second logic gate are coupled between the first multiplexing circuitry and the second multiplexing circuitry;
a gate of the first transistor is coupled to an output of the first logic gate; and
a gate of the second transistor is coupled to an output of the second logic gate, and/or
wherein the first logic gate is a NAND gate and the second logic gate is a NOR gate.

6. The transmission driver of claim 5, wherein:
the SST driver further comprises a third transistor and a fourth transistor to serialize the data subgroups into the serial data stream based on the delayed quadrature clock, wherein:
the third transistor has the same source and drain connections as the first transistor, and the fourth transistor has the same source and drain connections as the second transistor; and
the transmission driver further comprises a third logic gate and a fourth logic gate configured to respectively control the third transistor and the fourth transistor.

7. The transmission driver of claim 5, wherein a shared pair of inputs is provided to the first logic gate and the second logic gate, and/or
wherein the shared pair of inputs comprises:
a bit from one of the data subgroups; and
the delayed quadrature clock.

8. The transmission driver of one of claims 1 to 7, wherein the SST driver further comprises at least one impedance-tuning transistor configured to control an impedance associated with transmitting the serial communication.

9. A method of operating a transmission driver for serial communication, the method comprising:
partially serializing, at first multiplexing circuitry, a data group into data subgroups based on an in-phase clock;
delaying, at the first multiplexing circuitry, a quadrature clock corresponding to the in-phase clock, wherein the delay is based on a latency of the partial serializing; and
serializing, at a source-series terminated (SST) driver of second multiplexing circuitry and based on the delayed quadrature clock, the data subgroups into a serial data stream based on the delayed quadrature clock.

10. The method of claim 9, wherein:
the partially serializing comprises arranging a four-bit data group into a pair of two-bit data groups; and
the serializing comprises arranging the pair of two-bit data groups into the serial data stream.

11. The method of claim 9 or 10, further comprising delaying, at a unit interval shifter of the first multiplexing circuitry, a time when bits of the data group are partially serialized, or
wherein the serializing, at the SST driver and based on the delayed quadrature clock, comprises serializing using a first transistor and a second transistor, and/or
further comprising respectively controlling the first transistor and the second transistor using a first logic gate and a second logic gate, wherein:
the first logic gate and the second logic gate are coupled between the first multiplexing stage and the second multiplexing stage;
a gate of the first transistor is coupled to the first logic gate; and
a gate of the second transistor is coupled to the second logic gate.

12. The method of claim 11, wherein:
controlling the first transistor using the first logic gate comprises using a NAND gate; and
controlling the second transistor using the second logic gate comprises using a NOR gate.

13. The method of claim 11, wherein the serializing, at the SST driver and based on the delayed quadrature clock, further comprises serializing using a third transistor and a fourth transistor, and the method further comprises respectively controlling the third transistor and the fourth transistor using a third logic gate and a fourth logic gate, or
further comprising providing, from the first multiplexing circuitry, a shared pair of inputs to the first logic gate and the second logic gate, and/or
wherein providing the shared pair of inputs comprises providing:
a bit from one of the data subgroups; and
the delayed quadrature clock.

14. The method driver of one of claims 9 to 13, further comprising controlling an output impedance associated with transmitting the serial communication using an impedance-tuning transistor of the second multiplexing stage.

15. Source-series terminated (SST) driver circuitry configured to provide a serial data stream based at least in part on a delayed quadrature clock, the SST driver circuitry comprising:
a first transistor coupled to a first logic gate, wherein the first logic gate is configured to provide control signals for the first transistor based on first and second bits of a two-bit group and the delayed quadrature clock; and
a second transistor coupled to a second logic gate, wherein the second logic gate is configured to provide control signals for the second transistor based on the first and second bits of the two-bit group and the delayed quadrature clock; wherein:
the first transistor and the second transistor are configured to serialize, based on the respective control signals, the two-bit group into the serial data stream.
